# FASCICULE DE BREVET EUROPEEN

(11) **EP 3 843 271 B1**
(45) Date de publication et mention de la délivrance du brevet: **13.12.2023**
(21) Numéro de dépôt: 20216847.2
(22) Date de dépôt: 23.12.2020
(51) Int. Cl.: H03K 17/96

(54) **TOUCHE SENSITIVE POUR BOÎTIER TACTILE, FILM CAPACITIF COMPRENANT UNE TELLE TOUCHE SENSITIVE ET BOÎTIER TACTILE COMPRENANT UN TEL FILM CAPACITIF**
TOUCH-TASTE FÜR BERÜHRUNGSEMPFINDLICHES GEHÄUSE, KAPAZITIVE FOLIE, DIE EINE SOLCHE TOUCH-TASTE UMFASST, UND BERÜHRUNGSEMPFINDLICHES GEHÄUSE, DAS EINE SOLCHE KAPAZITIVE FOLIE UMFASST
SENSITIVE KEY FOR TOUCH-SENSITIVE HOUSING, CAPACITIVE FILM COMPRISING SUCH A SENSITIVE KEY AND TOUCH-SENSITIVE HOUSING COMPRISING SUCH A CAPACITIVE FILM

(30) Priorité: 24.12.2019 FR 1915570
(43) Date de publication de la demande: 30.06.2021
(73) Titulaire: Somfy Activites SA, 74300 Cluses (FR)
(72) Inventeur: ROBIN, Serge, 74300 Cluses (FR); DEZEUZE, Yoann, 74300 Cluses (FR); FERNANDEZ-ALONSO, Marcos, 48930 Getxo (Vizcaya) (ES); BOUDJIET, Mohand-Tayeb, 38000 Grenoble (FR); GRAS, Antoine, 33240 Val de Virvee (FR)
(74) Mandataire: Lavoix

(56) Documents cités:
- DE-A1-102017 128 044
- US-A1- 2014 332 361

## Description

La présente invention concerne une touche sensitive ou capacitive pour boîtier tactile. La présente invention concerne également un film capacitif comprenant une telle touche sensitive. L'invention concerne également un boîtier tactile comprenant un tel film capacitif.

Il est connu de fabriquer des boîtiers tactiles comprenant au moins une touche sensitive comprenant un capteur sensitif, avec des électrodes arrangées sur différentes couches d'un circuit et connectées à un pilote. Dans ces boîtiers tactiles, les touches sensitives sont principalement rondes, et leur diamètre est sensiblement égal à celui d'un doigt, par exemple 5mm ou 7mm. La détection d'un actionnement d'une touche sensitive se base sur le principe suivant : lorsque l'utilisateur approche son doigt de la touche, l'environnement électrique entre une électrode émettrice du capteur sensitif et une électrode réceptrice du capteur sensitif est perturbé. En effet, lors de cette action, une grande partie du champ électrique est conduite à la Terre et n'est donc pas reçue par le récepteur. Une diminution de capacitance est détectée par un convertisseur.

Un exemple connu de touche sensitive est divulgué dans le document DE 10 2017 128044 A1, dans lequel des première et deuxième électrodes sont chacune formées par des pastilles reliées entre elles par une piste interne.

Lorsque de telles touches sensitives sont intégrées à un boîtier tactile utilisant également des émetteurs et/ou récepteurs radiofréquences pour une communication entre le boîtier tactile et, par exemple, une centrale d'alarme, des appuis parasites de touches dus aux radiofréquences risquent d'être détectés et ainsi induire des erreurs lorsque, par exemple, un code est entré sur le boîtier tactile. En effet, la détection d'appui sur une touche est effectuée en détectant une variation d'une grandeur électrique, par exemple une tension ou un courant, dont l'amplitude est faible, de l'ordre de 10⁻¹² à 10⁻¹⁵ farad. Les radiofréquences émises par des antennes radio induisent des variations de ce même ordre de grandeur, ce qui peut provoquer des détections intempestives d'appui de touche.

C'est à cet inconvénient que compte remédier l'invention en proposant des touches sensitives immunes aux radiofréquences utilisées par un émetteur et/ou récepteur de communication localisé à proximité des touches sensitives, en particulier dans un même boîtier.

A cet effet, l'invention concerne une touche sensitive pour boîtier tactile selon la revendication 1.

Grâce à l'invention, l'arrangement des électrodes permet de diminuer les longueurs des pistes qui risquent de détecter des radiofréquences parasites, tout en maintenant, grâce aux pastilles juxtaposées et appartenant alternativement à l'une ou l'autre des électrodes, une surface importante de détection d'un appui. Cela permet de limiter au maximum les appuis de touche intempestifs liés aux perturbations radiofréquences extérieures, notamment aux perturbations par des radiofréquences utilisées par un émetteur-récepteur radiofréquences à proximité de la touche sensitive.

Selon des aspects avantageux mais non obligatoires de l'invention, une telle touche sensitive comporte une ou plusieurs des caractéristiques définies dans les revendications dépendantes 2-7.

L'invention concerne également un film capacitif selon la revendication dépendante 8.

Ce film capacitif induit les mêmes avantages que ceux mentionnés ci-dessus au sujet de la touche sensitive.

Selon des aspects avantageux mais non obligatoires de l'invention, un tel film capacitif comporte une ou plusieurs des caractéristiques définies dans les revendications dépendantes 9-12.

Selon un autre aspect, l'invention concerne un boîtier tactile selon la revendication dépendante 13.

Ce boîtier tactile induit les mêmes avantages que ceux mentionnés ci-dessus au sujet de la touche sensitive.

Avantageusement, le boîtier tactile comporte les caractéristiques définies dans la revendication dépendante 14.

L'invention sera mieux comprise et d'autres avantages de celle-ci apparaîtront plus clairement à la lumière de la description qui va suivre d'un mode de réalisation d'une touche sensitive, d'un film capacitif comprenant une telle touche sensitive et d'un boîtier tactile comprenant un tel filtre capacitif, donnée uniquement à titre d'exemple et faite en référence aux dessins, dans lesquels :
[Fig. 1] la figure 1 est une vue schématique en perspective d'un boîtier conforme à l'invention, comprenant un film capacitif et des touches conformes à l'invention ;
[Fig. 2] la figure 2 est une vue schématique de dessus du film capacitif du boîtier de la figure 1 ;
[Fig. 3] la figure 3 est une vue du détail III de la figure 2, montrant la zone d'appui d'une touche sensitive conforme à l'invention ;
[Fig 4] la figure 4 est une vue similaire à la figure 3, montrant des électrodes et des pistes externes de raccordement de la touche sensitive ; et
[Fig. 5] la figure 5 est une coupe partielle selon le plan V de la figure 2.

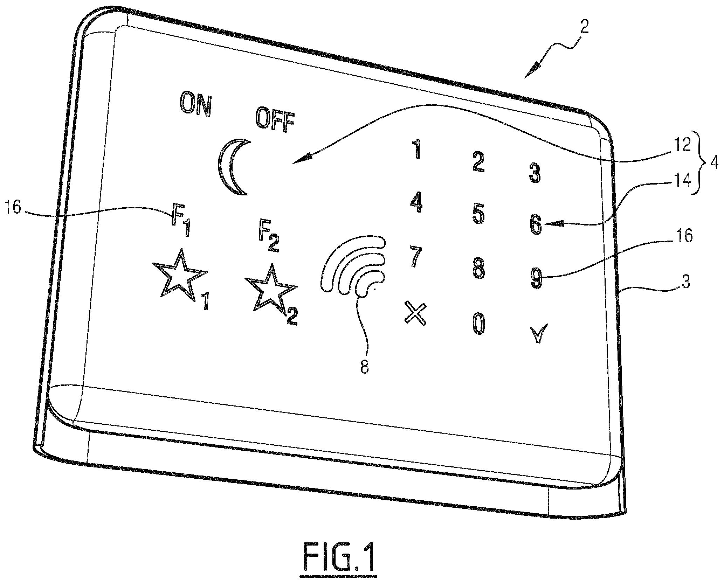

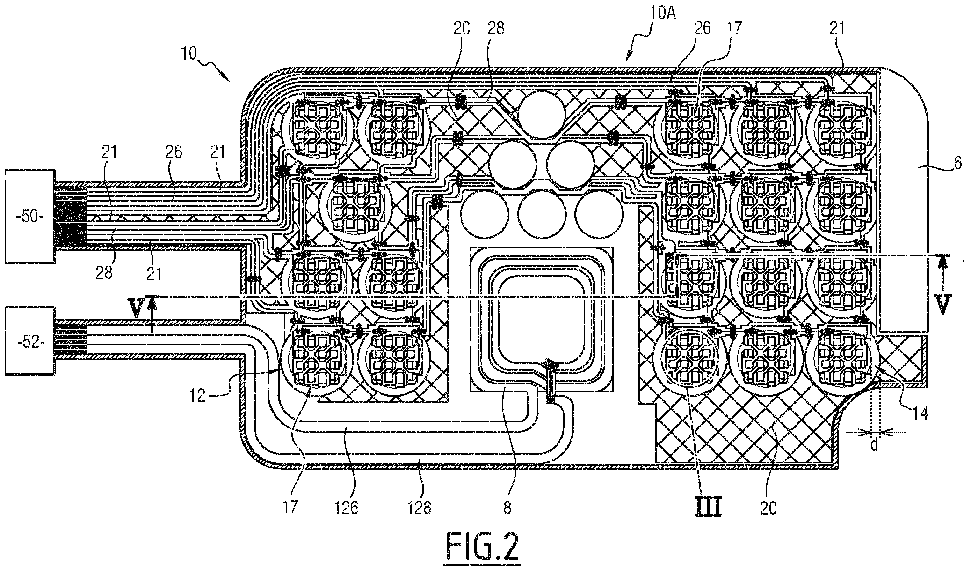

Un boîtier tactile 2 est représenté sur la figure 1. Ce boîtier tactile 2 est destiné à contrôler, par exemple, une alarme ou des fonctions domotiques d'un logement. Ce boîtier tactile 2 comprend un clavier 4 destiné à entrer des instructions d'un utilisateur, par exemple désactiver l'alarme ou fermer des volets, le clavier comprenant des touches sensitives 16. Le boîtier tactile 2 comprend également un émetteur et/ou un récepteur radiofréquences comprenant une première antenne radio 6, visible à la figure 2 et destinée à transmettre des informations enregistrées par le boîtier tactile 2 à un dispositif distant, par exemple une centrale d'alarme et/ou à recevoir des informations d'état, par exemple relatives au statut du dispositif distant, par exemple de la centrale d'alarme, ou de commande, par exemple de la part d'un émetteur radio nomade. Le boîtier 2 est également équipé d'une deuxième antenne radio 8, de communication en champ proche, notée NFC pour « Near Field Communication » en Anglais, destinée à être utilisée pour la détection d'un badge passif d'un utilisateur, par exemple pour reconnaître et identifier un utilisateur porteur du badge et communiquer avec le dispositif distant, par exemple dans le but de désactiver l'alarme gérée par la centrale d'alarme. Ainsi, de manière générale, le boîtier tactile 2 est utilisé pour permettre à un utilisateur une saisie d'ordres de commande à destination du dispositif distant et/ou pour afficher des informations relatives au dispositif distant. La communication entre le boîtier tactile 2 et le dispositif distant s'effectue par ondes radiofréquences ou en filaire.

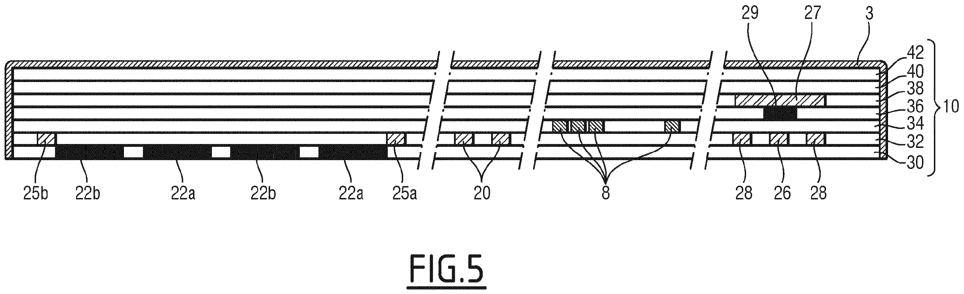

Le clavier 4 est intégré à un film capacitif 10, mieux visible sur les figures 2 et 5, qui est disposé sous un capot 3 du boîtier tactile 2 qui est visible à la figure 1. Un schéma du clavier 4 est plus particulièrement visible à la figure 2. Ce clavier comprend deux pavés 12 et 14. Le pavé 12 est situé à gauche de la deuxième antenne 8, qui est placée au centre du film capacitif 10. Il comprend une ou plusieurs touches fonctionnelles sensitives 16, chacune correspondant par exemple à une fonction particulière de commande du dispositif distant. Le pavé 12 permet de piloter une ou plusieurs fonctions domotiques, par exemple la fermeture ou l'ouverture d'un volet ou l'allumage de lumières. Le pavé 14 est situé entre la deuxième antenne radio 8 et la première antenne radio 6. Ainsi, les pavés 12, 14 sont placés de part et d'autre de la deuxième antenne radio 8. Le pavé 14 est un pavé numérique permettant, par exemple, de désactiver l'alarme en entrant un code formé de chiffres. Chaque pavé 12 et 14 est composé de multiples touches sensitives 16.

Dans cet exemple, le premier pavé 10 comprend sept touches sensitives 16 et le deuxième pavé 12 comprend au moins dix touches sensitives 16, par exemple douze touches sensitives 16. Le nombre de touches sensitives des pavés 10 et 12 peut, en variante, être différent. Leur positionnement par rapport aux antennes 6 et 8 peut également être différent.

Les touches sensitives 16 des pavés 10 et 12 sont couplées, ainsi que la deuxième antenne radio 8, à une masse non représentée et sont isolées entre elles par un maillage de masse 20. Le maillage de masse 20 permet d'améliorer l'immunité du clavier 4 par rapport à des détections intempestives d'appuis de touches causées par des fréquences extérieures ayant pour origine, notamment, la première antenne radio 6, en limitant de manière importante les perturbations électromagnétiques. L'immunité du clavier 4 aux perturbations est également améliorée par la construction spécifique d'électrodes 7, 9 des touches sensitives 16 décrites ci-après. Le maillage de masse 20 est constitué de pistes conductrices formant une grille. Les pistes conductrices ont par exemple une largeur de 0,4 mm et se croisent entre elles en forment des carrés de 3,3 mm sur tout le film capacitif 10 à l'exception de zones réservées pour la deuxième antenne radio 8, la première antenne radio 6 et les touches sensitives 16.

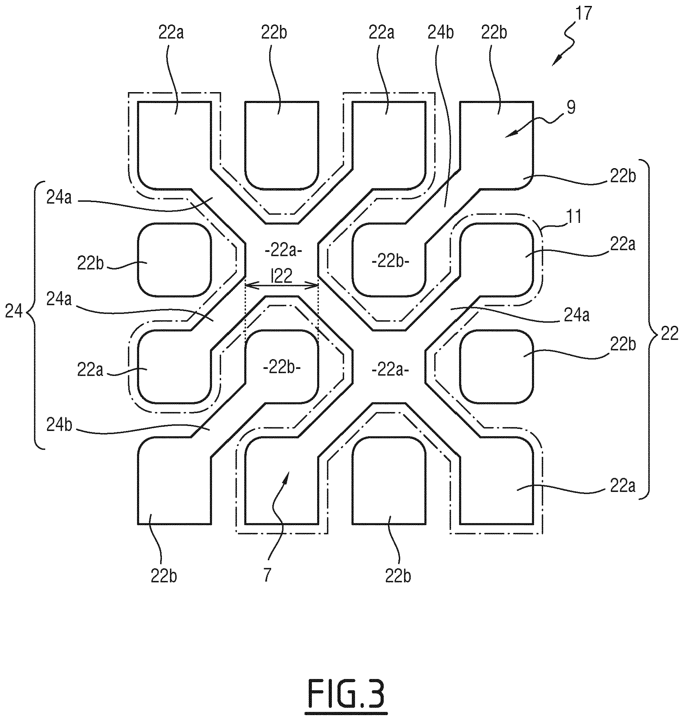

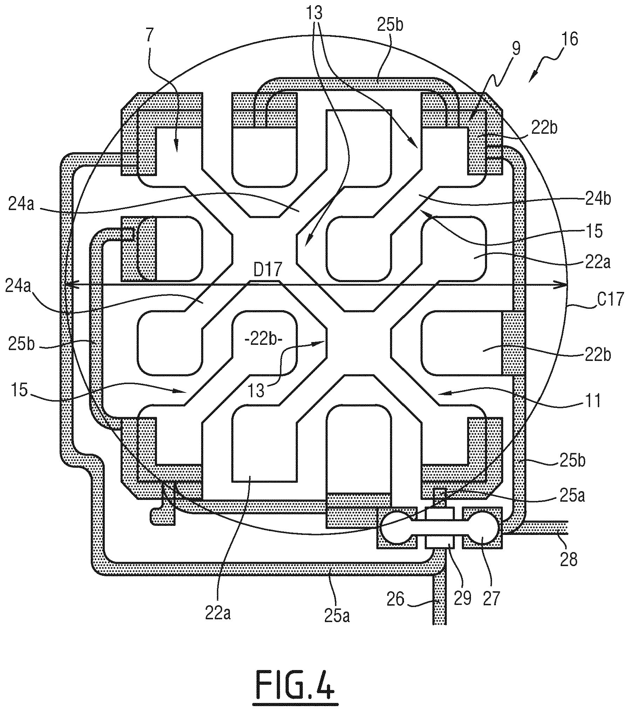

Toutes les touches sensitives 16 sont identiques. Une touche sensitive 16 est plus précisément illustrée sur les figures 3 et 4, représentant un mode préféré de réalisation. Cette touche sensitive 16 comprend une zone d'appui 17 de forme carrée, inscrite dans un cercle C17 de diamètre D17 égal à 12 mm. Afin d'éviter au maximum des interférences entre la deuxième antenne radio 6 et la touche sensitive 16, la touche sensitive 16 comprend une première électrode 7 et une deuxième électrode 9 comprenant chacune des pastilles 22. La touche sensitive 16 comprend également des pistes internes 24, cheminant à l'intérieur de la zone d'appui 17 et reliant une partie des pastilles 22 entre elles. Les pastilles 22 sont arrangées en matrice, comprenant au moins deux lignes et au moins deux colonnes, les pastilles 22 de chaque électrode 7, 9 étant arrangées alternativement dans les lignes et les colonnes de la matrice. Dans l'exemple des figures 3 et 4, la matrice comprend quatre lignes et quatre colonnes, il y a donc seize pastilles 22 dans la zone d'appui 17. Le nombre de lignes et le nombre de colonnes de la matrice sont de préférence égaux. Ainsi, les pastilles 22 sont arrangées sous forme de damier. La zone d'appui 17, constituée par la réunion des électrodes 7 et 9, est délimitée par le contour extérieur des pastilles 22 des deux électrodes 7, 9. Cette zone d'appui est représentée seule à la figure 3. Chaque électrode 7, 9 est isolée de l'autre. L'électrode 7 est reliée à un circuit de détection 26, par des pistes externes de raccordement 25a. L'électrode 9 est reliée à un autre circuit de détection 28, par des pistes externes de raccordement 25b. Les pistes de raccordement 25a et 25b et les deux circuits 26, 28 sont isolés l'un de l'autre. Les deux circuits 26, 28 ne font pas partie de la touche sensitive 16 à laquelle ils sont raccordés, mais servent à son fonctionnement. Les pistes de raccordement 25a et 25b sont arrangées à l'extérieur et le long de la zone d'appui 17.

La première électrode 7 comprend certaines des pastilles 22, que l'on nomme premières pastilles 22a, et certaines des pistes internes 24, que l'on nomme premières pistes internes 24a. Les premières pastilles 22a sont toutes reliées entre elles par les premières pistes internes 24a, qui s'étendent, dans le plan de la figure 3, selon des directions parallèles aux deux diagonales de la matrice. Les premières pastilles 22a et les premières pistes internes 24a qui les relient forment ensemble un motif d'ossature 11 de la touche sensitive 16, entouré par des traits d'axe sur la figure 3. Le motif d'ossature 11 a la forme d'une croix à double traverse inscrite dans un rectangle, plus particulièrement dans un carré, qui comprend la matrice. Les premières pistes internes 24a comprennent une piste principale qui s'étend entre deux premières pastilles situées dans deux coins opposés de la matrice et quatre pistes secondaires qui s'étendent perpendiculairement à la piste principale, par groupes de deux réparties de part et d'autre de la piste principale. Il y a donc cinq premières pistes 24a en tout. Certaines des premières pastilles 22a, à savoir les deux premières pastilles 22a situées aux deux extrémités de la branche la plus longue du motif d'ossature 11 formée par la piste 24a principale, sont reliées au premier circuit 26 par les pistes externes de raccordement 25a. Ces pistes 25a sont arrangées à l'extérieur et le long de la zone d'appui 17, en projection sur le plan de la figure 3, à savoir le long de ses côtés gauche et inférieur à la figure 4.

La deuxième électrode 9 comprend certaines des pastilles 22, que l'on nomme deuxièmes pastilles 22b, et certaines des pistes internes 24, que l'on nomme deuxièmes pistes internes 24b. Les deuxièmes pastilles 22b sont arrangées dans des espaces 13 laissés libres par le motif d'ossature 11, au sein de la zone d'appui 17, les pastilles 22 juxtaposées adjacentes dans cette zone d'appui faisant alternativement partie de la première et de la deuxième électrode 7, 9. Les pastilles 22b se trouvant sur une diagonale du carré sont reliées par paire par une deuxième piste interne 24b. Ainsi, la deuxième électrode 9 comprend deux paires de deuxièmes pastilles 22b reliées par des pistes internes 24b. Il y a donc deux deuxièmes pistes 24a en tout. Ces deuxièmes pistes internes 24b sont également arrangées dans des espaces 15 laissés libres par le motif d'ossature 11, au sein de la zone d'appui 17. Les autres deuxièmes pastilles 22b de la deuxième électrode 9 sont reliées entre elles, aux deux paires de deuxièmes pastilles 22b et à un circuit de détection 28, qui n'appartient pas à l'électrode 9, par les pistes externes de raccordement 25b.

Ainsi, les pastilles 22 forment deux groupes :
- les premières pastilles 22a de la première électrode 7 reliées entre elles par les premières pistes internes 24a et au circuit 26 de détection par les pistes externes de raccordement 25a et
- les deuxièmes pastilles 22b de la deuxième électrode 9 dont certaines sont reliées entre elles par les pistes internes 24b et dont toutes sont reliées entre elles et au circuit 28 par les pistes externes de raccordement 25b.

Dans la configuration du mode de réalisation de la figure 3, les pastilles 22a, 22b de la première et de la deuxième électrode 7, 9 sont arrangées de manière régulière suivant chaque ligne et chaque colonne de la matrice.

L'agencement des pastilles 22a, 22b et des pistes internes 24a, 24b au sein des électrodes 7, 9 est prévu pour minimiser la longueur des pistes internes 24 et des pistes de raccordement externes 25a et 25b reliant les pastilles 22 entre elles, pour maximiser la surface des pastilles 22 au sein de la zone d'appui 17 et ainsi minimiser le risque d'interférences avec les radiofréquences. En effet, les perturbations détectées dans l'environnement d'une touche sensitive 16 sont proportionnelles à la somme des longueurs des électrodes 7, 9. En maximisant la largeur des pastilles 22 et des pistes internes 24, on augmente la surface de détection au niveau de la zone d'appui 17, pour une même longueur d'électrode 7, 9.

Dans le mode de réalisation décrit, chaque pastille 22 est de forme globalement carrée, avec une arête de côté dont la longueur ℓ22 est égale à 1,6 mm. Les sommets des carrés des pastilles 22 peuvent être tronqués pour augmenter la longueur du carré tout en respectant une distance nécessaire entre les pastilles 22 et les pistes internes 24 de l'autre électrode pour éviter tout risque de contact électrique.

En pratique, la longueur ℓ22 peut être choisie entre 1 et 2 mm.

L'optimisation de la longueur ℓ22 du côté des pastilles 22 permet également d'avoir des pistes internes 24 entre deux pastilles 22 les plus courtes possibles pour limiter les interférences avec l'antenne radio 6.

De manière alternative à un arrangement en matrice ou damier, les pastilles 22 peuvent être arrangées plus irrégulièrement, suivant des arcs de cercle. Le nombre de pastilles 22a et 22b peut être égal ou légèrement différent, de sorte à occuper le plus d'espace possible au niveau de la zone d'appui 17.

Toujours dans un souci de limiter les perturbations par les radiofréquences, chaque pastille 22 est située, de préférence, à une distance d minimum du maillage de masse 20, du même ordre de grandeur que la longueur ℓ22 du côté d'une pastille 22, par exemple à une distance minimum de 1,5 mm.

La figure 5 présente, en coupe, la composition du film capacitif 10 intégrant le clavier 4 et la deuxième antenne 8.

Le film capacitif 10 est réalisé par sérigraphie sur différentes couches, avec deux niveaux de métallisation pour les circuits 26, 28 et pour le maillage de masse 20, un niveau conducteur transparent pour les électrodes 7, 9, un niveau diélectrique et enfin un niveau de métallisation pour l'impression de la deuxième antenne 8, dont la conductivité doit être supérieure à celle des autres niveaux de métallisation.

Le film capacitif 10 comprend autant de premiers circuits 26 qu'il y a de colonnes sur le clavier 4 et autant de deuxièmes circuits 28 qu'il y a de lignes sur le clavier 4. Ainsi, sur l'exemple des figures, le film capacitif 10 comprend six premiers circuits 26 et quatre deuxièmes circuits 28.

Une première couche 30 comprend les pastilles 22a, 22b, et les pistes internes 24a et 24b des électrodes 7, 9, qui sont formées en encre à base de poly(3,4-éthylènedioxythiophène), notée PEDOT. Une deuxième couche 32 de métallisation comprend les premiers circuits 26, les deuxièmes circuits 28 et le maillage de masse 20. Ces circuits 26, 28 et ce maillage de masse 20 sont formés avec une première encre à base de microparticules d'argent. Des plots d'interconnexion, non représentés, sont également sérigraphiés sur cette deuxième couche. Une troisième couche 34 est superposée sur la deuxième couche 32 et comprend la deuxième antenne 8, qui est formée avec une deuxième encre à base de microparticules d'argent, dont la conductivité est supérieure à celle de la première encre à base de microparticules d'argent. Une quatrième couche 36 est superposée sur la troisième couche 34. Cette quatrième couche 36 comprend des isolants imprimés 29 formant la base de ponts de connexion 27, permettant un croisement sans court-circuit entre les circuits 26, 28, comme visible à la figure 5. Ces isolants sont situés à l'extérieur de la zone d'appui 17. Une cinquième couche 38 est superposée à la quatrième couche 36 et comprend les ponts de connexion 27 pour le croisement des premiers circuits 26 et des deuxièmes circuits 28. Ces croisements s'effectuent en dehors des zones d'appui 17 des touches sensitives 16 et sont superposés 29 aux isolants de la quatrième couche 34. Ces ponts de connexion 27 sont également formés avec la première encre à base de microparticules d'argent. Une sixième couche 40 est superposée la cinquième couche 38 et comprend une encre carbone permettant de solidifier l'extrémité des pistes conductrices 24 pour faciliter la liaison avec des connecteurs, non représenté sur les figures, permettant de connecter le film capacitif 10 à une carte électronique de pilotage du clavier 4. Une septième couche 42 facultative est superposée à la sixième couche 40. Cette septième couche 42 est une couche de passivation ou protection des capteurs pour les essais du film capacitif 10.

Les différentes couches peuvent être réalisées et empilées dans l'ordre des couches citées ci-dessus, ou différemment. En particulier, le film sensitif peut être réalisé par empilement de la première couche 30, puis de la sixième couche 40, puis de la cinquième couche 38, puis enfin des deuxième et troisième couches 32 et 34. Les deuxième et troisième couches 32 et 34 peuvent également être imprimées en même temps.

Afin d'illuminer les touches sensitives 16, des diodes électroluminescentes sont placées directement sous le filtre capacitif 10 sur le circuit imprimé.

L'encre PEDOT des électrodes 7, 9 et des pistes internes 24 étant translucide, la lumière peut passer et les pastilles 22 et les pistes internes 24 ne sont pas visibles depuis l'extérieur, lorsqu'elles sont éclairées à travers le film capacitif 10.

Comme visible à la figure 2, le boîtier tactile 2 comprend un premier connecteur 50 raccordé sur un arrangement de pistes conductrices. Ces pistes conductrices forment, d'une part, les circuits 26 et 28 reliant les touches sensitives 16 arrangées suivant des lignes et des colonnes du film capacitif 10 pour former le clavier sensitif 4. Ces pistes conductrices forment, d'autre part des circuits de masse 21. Les pistes conductrices formant les circuits 21, 26 et 28 sont arrangées parallèlement entre elles au niveau d'un bord 10A du film capacitif 10. Le premier connecteur 50 couple les deux pistes latérales les plus externes et la ou les deux pistes centrales à la masse. En d'autres termes, les circuits de masse 21 sont formés par les deux pistes latérales externes et la ou les pistes centrales. Les pistes restantes d'un côté de la ou des pistes centrales forment les circuits 28 et sont reliées aux touches sensitives situées sur une même ligne du clavier 4 sensitif. Les pistes restantes, situées de l'autre côté de la ou des pistes centrales, forment les circuits 26 et sont reliées aux touches sensitives 16 situées sur une même colonne du clavier 4 sensitif. Ainsi, la ou les pistes centrales, couplées à la masse, séparent les pistes conductrices reliées à des lignes du clavier tactile des pistes conductrices reliées à des colonnes du clavier tactile.

Le boîtier tactile 2 comprend également un deuxième connecteur 52 raccordé sur un arrangement de circuits 126 et 128 reliés à la deuxième antenne 8.

Les connecteurs 50 et 52 permettent de brancher le film capacitif 10 a un contrôleur non représenté, qui appartient également au boîtier tactile 2 et qui est avantageusement disposé derrière ce film.

Le circuit 28 est un premier circuit de détection qui fonctionne comme un émetteur et correspond par exemple aux lignes du clavier 4. Le circuit 26 est un deuxième circuit de détection 26 qui fonctionne comme un récepteur et correspond par exemple aux colonnes du clavier 4. En scannant l'état des électrodes l'une après l'autre, le contrôleur est capable de détecter une perturbation, liée au positionnement d'un doigt sur une des touches sensitives, et d'en déterminer les coordonnées au niveau du clavier. Ainsi, le contrôleur détermine la ou lesquelles des touches sensitives 16 sont activées.

En variante, par exemple, chaque pastille 22 est un carré de 2 mm ou de 2,5 mm de côté.

En variante, le nombre de touches de chaque pavé peut être différent, par exemple le premier pavé 10 peut comprendre quatre touches sensitives 16 ou dix touches sensitives 16 et le deuxième pavé 12 peut comprendre seize touches sensitives 16 ou deux touches sensitives 16.

Selon une autre variante, le clavier 4 peut comprendre plus de pavés, par exemple trois pavés ou un seul pavé.

En variante, la distance entre chaque électrode 7, 9 et le maillage de masse est différente, par exemple 2 mm. Autrement dit, la distance d peut être égale à 2 mm.

## Revendications

1. Touche sensitive (16) pour boîtier tactile (2), la touche sensitive comprenant des électrodes (7, 9) et des pistes externes (25a, 25b) de raccordement électrique à des circuits (26, 28), dans laquelle une première des électrodes (7) comprend des pastilles (22a) et des pistes internes (24a), les pastilles étant toutes reliées entre elles par les pistes internes (24a), les pastilles (22a) et les pistes internes (24a) de la première électrode (7) formant un motif d'ossature (11) de la touche sensitive (16), certaines des pastilles (22a) de la première électrode (7) étant reliées à un premier des circuits (26) par des premières des pistes externes de raccordement (25a), une deuxième des électrodes (9) comprenant des pastilles (22b) arrangées dans des espaces laissés libres (13) par le motif d'ossature (11), les pastilles de la deuxième électrode étant reliées à un deuxième des circuits (28) par des deuxièmes des pistes externes de raccordement (25b), de sorte que deux pastilles (22) adjacentes appartiennent alternativement à la première électrode (7) et à la deuxième électrode (9) et sont alternativement reliées à une des premières pistes externes de raccordement (25a) et à une des deuxièmes pistes externes de raccordement (25b), la touche sensitive comprenant une zone d'appui (17), constituée par la réunion des première et deuxième électrodes (7, 9) et délimitée par le contour extérieur des pastilles (22a, 22b) des première et deuxième électrodes, les premières et deuxièmes pistes externes de raccordement (25a, 25b) étant arrangées à l'extérieur et le long de la zone d'appui (17).

2. Touche sensitive (16) selon la revendication 1, **caractérisée en ce que** les pastilles (22) de la première et de la deuxième électrode (7, 9) sont arrangées dans une matrice comprenant des lignes et des colonnes, les pastilles (22) de la première et de la deuxième électrode (7,9) étant arrangées régulièrement et de façon alternative, suivant chaque ligne et chaque colonne de la matrice.

3. Touche sensitive (16) selon la revendication 2, **caractérisée en ce que** la matrice comprend quatre lignes et quatre colonnes et la touche sensitive (16) comprend seize pastilles (22).

4. Touche sensitive (16) selon l'une des revendications précédentes, **caractérisée en ce que** les premières et deuxièmes pistes externes de raccordement (25a, 25b) sont arrangées à l'extérieur de la zone d'appui (17) délimitée par les pastilles (22) des première et deuxième électrodes (7, 9).

5. Touche sensitive (16) selon l'une des revendications précédentes, **caractérisée en ce que** chaque pastille (22) a une forme carrée dont l'arête mesure entre 1 et 2,5 mm, en étant de préférence égale à 1,6 mm.

6. Touche sensitive (16) selon l'une quelconque des revendications précédentes, **caractérisée en ce que** les pastilles (22) et les pistes internes (24) sont sérigraphiées en encre transparente, par exemple à base de poly(3,4-éthylènedioxythiophène).

7. Touche sensitive (16) selon la revendication 3, **caractérisée en ce que** les premières et deuxièmes pistes externes de raccordement (25a, 25b) sont sérigraphiées en encre à base de microparticules d'argent.

8. Film capacitif (10) comprenant au moins deux touches sensitives (16), des circuits (26, 28) raccordés aux touches sensitives et une antenne de communication en champ proche (8), **caractérisé en ce que** chaque touche sensitive est selon l'une quelconque des revendications précédentes et **en ce que** le film capacitif comprend un maillage de masse (20).

9. Film capacitif (10) selon la revendication 8, **caractérisé en ce que** l'antenne de communication en champ proche (8) est placée au centre du film capacitif et deux pavés (12, 14), comprenant chacun au moins deux touches sensitives (16), sont disposés de part et d'autre de l'antenne de communication en champ proche.

10. Film capacitif (10) selon l'une des revendications 8 ou 9, **caractérisé en ce qu'**il est réalisé par sérigraphie sur différentes couches, avec deux niveaux de métallisation pour les premières et deuxièmes pistes externes de raccordement (25a, 25b) et les circuits (26, 28), un niveau conducteur transparent pour les électrodes (7, 9), un niveau diélectrique et un niveau de métallisation pour l'impression de la deuxième antenne (8).

11. Film capacitif (10) selon la revendication 8 à 10, **caractérisé en ce qu'**il comprend :
• une première couche (30) comprenant les premières et deuxième électrodes (7, 9) ;
• une deuxième couche (32) comprenant les premières et deuxièmes pistes de raccordement externes (25a, 25b)
• une troisième couche (34) comprenant l'antenne de communication en champ proche (8) ;
• une quatrième couche (36) d'isolation de ponts (27) de croisement des pistes du premier et du deuxième circuit ;
• une cinquième couche (38) comprenant les ponts (27) de croisement des pistes du premier et du deuxième circuit ;
• une sixième couche (40) comprenant une encre carbone disposée aux extrémités des circuits (26, 28).

12. Film capacitif (10) selon l'une des revendications 10 ou 11, caractérisé en ce la deuxième antenne (8) est formée avec une encre à microparticules d'argent, dont la conductivité est supérieure à celle de l'encre utilisée pour former les pistes externes de raccordement (25a, 25b) et les circuits (26, 28).

13. Boîtier tactile (2) comprenant une antenne radio (6) et un circuit imprimé, **caractérisé en ce qu'**il comprend également un film capacitif (10) selon l'une quelconque des revendications 8 à 12 et des diodes pour illuminer la ou les touches sensitives (16).

14. Boîtier tactile (2) selon la revendications 13, **caractérisé en ce qu'**il comprend un premier connecteur (50), raccordé avec un premier arrangement de pistes conductrices (21, 26, 28) dont certaines (26, 28) relient des touches sensitives (16) arrangées suivant des lignes et des colonnes du film capacitif (10), les pistes conductrices étant arrangées parallèlement entre elles au niveau d'un bord (10A) du film capacitif (10), le premier connecteur couplant deux pistes latérales externes et la ou les deux pistes centrales (21) à la masse, les pistes restantes d'un côté de la ou des pistes centrales formant un premier circuit de détection (28) relié aux touches sensitives situées sur une même ligne du film capacitif (10) et les pistes restantes de l'autre côté de la ou des pistes centrales formant le deuxième circuit de détection (26) relié aux touches sensitives situées sur une même colonne du film capacitif (10).

## Patentansprüche

1. Touch-Taste (16) für berührungsempfindliches Gehäuse (2), wobei die Touch-Taste Elektroden (7, 9) und äußere Leiterbahnen (25a, 25b) zur elektrischen Verbindung mit Schaltkreisen (26, 28) umfasst, wobei eine erste Elektrode (7) Pads (22a) und innere Leiterbahnen (24a) umfasst, wobei die Pads alle durch die inneren Leiterbahnen (24a) miteinander verbunden sind, wobei die Pads (22a) und die inneren Leiterbahnen (24a) der ersten Elektrode (7) ein Rahmenmuster (11) der Touch-Taste (16) formen, wobei einige der Pads (22a) der ersten Elektrode (7) über erste äußere Leiterbahnen (25a) mit einer ersten der Schaltungen (26) verbunden sind, wobei eine zweite der Elektroden (9) Pads (22b) umfasst, die in von dem Rahmenmuster (11) freigelassenen Räumen (13) angeordnet sind, wobei die Pads der zweiten Elektrode mit einer zweiten der Schaltungen (28) durch die zweiten äußeren Verbindungsbahnen (25b) verbunden sind, so dass zwei benachbarte Pads (22) abwechselnd zu der ersten Elektrode (7) und der zweiten Elektrode (9) gehören und abwechselnd mit einer der ersten äußeren Verbindungsbahnen (25a) und einer der zweiten äußeren Verbindungsbahnen (25b) verbunden sind. Die Touch-Taste umfasst einen Auflagebereich (17), der durch die Verbindung der ersten und zweiten Elektrode (7, 9) gebildet wird und durch die Außenkontur der Pads (22a, 22b) der ersten und zweiten Elektrode begrenzt wird, wobei die ersten und zweiten äußeren Verbindungsbahnen (25a, 25b) außerhalb und entlang des Auflagebereichs (17) angeordnet sind.

2. Touch-Taste (16) nach Anspruch 1, **dadurch gekennzeichnet, dass** die Pads (22) der ersten und der zweiten Elektrode (7, 9) in einer Matrix mit Zeilen und Spalten angeordnet sind, wobei die Pads (22) der ersten und der zweiten Elektrode (7, 9) regelmäßig und abwechselnd entlang jeder Zeile und jeder Spalte der Matrix angeordnet sind.

3. Touch-Taste (16) nach Anspruch 2, **dadurch gekennzeichnet, dass** die Matrix vier Zeilen und vier Spalten umfasst und die Touch-Taste (16) sechzehn Pads (22) umfasst.

4. Touch-Taste (16) nach einem der vorhergehenden Ansprüche, **dadurch gekennzeichnet, dass** die ersten und zweiten äußeren Anschlussbahnen (25a, 25b) außerhalb des durch die Pads (22) der ersten und zweiten Elektrode (7, 9) begrenzten Auflagebereichs (17) angeordnet sind.

5. Touch-Taste (16) nach einem der vorhergehenden Ansprüche, **dadurch gekennzeichnet, dass** jedes Pad (22) eine quadratische Form hat, deren Kante zwischen 1 und 2,5 mm misst, wobei sie vorzugsweise 1,6 mm beträgt.

6. Touch-Taste (16) nach einem der vorhergehenden Ansprüche, **dadurch gekennzeichnet, dass** die Pads (22) und die inneren Leiterbahnen (24) mit Siebdruck aus transparenter Tinte, z. B. auf der Basis von Poly(3,4-ethylendioxythiophen), bedruckt sind.

7. Touch-Taste (16) nach Anspruch 3, **dadurch gekennzeichnet, dass** die ersten und zweiten äußeren Anschlussbahnen (25a, 25b) mit Tinte auf der Basis von Silbermikropartikeln im Siebdruckverfahren bedruckt sind.

8. Kapazitive Folie (10) mit mindestens zwei Touch-Tasten (16), Schaltungen (26, 28), die mit den Touch-Tasten verbunden sind, und einer Nahfeldkommunikationsantenne (8), **dadurch gekennzeichnet, dass** jede Touch-Taste einem der vorhergehenden Ansprüche entspricht und dass die kapazitive Folie ein Massennetz (20) umfasst.

9. Kapazitive Folie (10) nach Anspruch 8, **dadurch gekennzeichnet, dass** die Nahfeldkommunikationsantenne (8) in der Mitte der kapazitiven Folie angeordnet ist und zwei Touch-Pads (12, 14), von denen jedes mindestens zwei Touch-Tasten (16) umfasst, auf beiden Seiten der Nahfeldkommunikationsantenne angeordnet sind.

10. Kapazitive Folie (10) nach einem der Ansprüche 8 oder 9, **dadurch gekennzeichnet, dass** sie durch Siebdruck auf verschiedenen Schichten hergestellt wird, mit zwei Metallisierungsebenen für die ersten und zweiten äußeren Anschlussbahnen (25a, 25b) und den Schaltkreisen (26, 28), einer transparenten leitenden Ebene für die Elektroden (7, 9), einer dielektrischen Ebene und einer Metallisierungsebene für den Druck der zweiten Antenne (8).

11. Kapazitive Folie (10) nach den Ansprüchen 8 bis 10, **dadurch gekennzeichnet, dass** sie Folgendes umfasst:
• eine erste Schicht (30), die die erste und zweite Elektrode (7, 9) umfasst;
• eine zweite Schicht (32), die die ersten und zweiten äußeren Verbindungsbahnen (25a, 25b) umfasst;
• eine dritte Schicht (34), die die Nahfeldkommunikationsantenne (8) umfasst;
• eine vierte Schicht (36) zur Isolierung von Brücken (27), die die Leiterbahnen des ersten und des zweiten Stromkreises kreuzen;
• eine fünfte Schicht (38), die die Brücken (27) umfasst, die die Leiterbahnen des ersten und des zweiten Stromkreises kreuzen;
• eine sechste Schicht (40) mit einer Kohlenstofftinte, die an den Enden der Schaltungen (26, 28) angeordnet ist.

12. Kapazitive Folie (10) nach einem der Ansprüche 10 oder 11, **dadurch gekennzeichnet, dass** die zweite Antenne (8) mit einer Tinte aus Silbermikropartikeln gebildet ist, deren Leitfähigkeit höher ist als die der Tinte, die zur Bildung der äußeren Anschlussbahnen (25a, 25b) und der Schaltkreise (26, 28) verwendet wird.

13. Berührungsempfindliches Gehäuse (2) mit einer Funkantenne (6) und einer gedruckten Schaltung, **dadurch gekennzeichnet, dass** es auch eine kapazitive Folie (10) nach einem der Ansprüche 8 bis 12 und Dioden zum Beleuchten der Touch-Taste(n) (16) enthält.

14. Berührungsempfindliches Gehäuse (2) nach Anspruch 13, **dadurch gekennzeichnet, dass** es einen ersten Verbinder (50) umfasst, der mit einer ersten Anordnung von Leiterbahnen (21, 26, 28) verbunden ist, von denen einige (26, 28) Touch-Tasten (16) verbinden, die in den Zeilen und Spalten der kapazitiven Folie (10) angeordnet sind, wobei die Leiterbahnen an einem Rand (10A) der kapazitiven Folie (10) parallel zueinander angeordnet sind, wobei der erste Verbinder zwei seitliche äußere Bahnen verbindet und wo die zwei Mittelbahnen existieren (21) diese mit der Masse verbindet, wobei die verbleibenden Bahnen auf der einen Seite der Mittelbahn(en) einen ersten Detektionsschaltkreis (28) bilden, der mit den Touch-Tasten verbunden ist, die sich auf einer Zeile der kapazitiven Folie (10) befinden und die verbleibenden Bahnen auf der anderen Seite davon, wo die Mittelbahnen den zweiten Detektionsschaltkreis (26) bilden, der mit den Touch-Tasten verbunden ist, die sich in derselben Spalte der kapazitiven Folie (10) befinden.

## Claims

1. Sensitive key (16) for a touch-sensitive housing (2), the sensitive key comprising electrodes (7, 9) and external tracks (25a, 25b) for electrical connection to circuits (26, 28), wherein a first of the electrodes (7) comprises pads (22a) and internal tracks (24a), the pads all being connected together by the internal tracks (24a), the pads (22a) and the internal tracks (24a) of the first electrode (7) forming a skeleton pattern (11) of the sensitive key (16), some of the pads (22a) of the first electrode (7) being connected to a first one of the circuits (26) by first ones of the external connection tracks (25a), a second one of the electrodes (9) comprising pads (22b) arranged in spaces left free (13) by the skeleton pattern (11), the pads of the second electrode being connected to a second one of the circuits (28) by a second one of the external connection tracks (25b), so that two adjacent pads (22) belong alternately to the first electrode (7) and to the second electrode (9) and are alternately connected to one of the first external connection tracks (25a) and to one of the second external connection tracks (25b), the sensitive key comprising a press zone (17) formed by the joining together of the first and second electrodes (7, 9) and delimited by the external contour of the pads (22a, 22b) of the first and second electrodes, the first and second external connecting tracks (25a, 25b) being arranged outside and along the press zone (17).

2. The sensitive key (16) according to claim 1, **characterised in that** the pads (22) of the first and second electrodes (7, 9) are arranged in a matrix comprising rows and columns, the pads (22) of the first and second electrodes (7, 9) being arranged regularly and in alternating fashion, along each row and each column of the matrix.

3. The sensitive key (16) according to claim 2, **characterised in that** the matrix comprises four rows and four columns and the sensitive key (16) comprises sixteen pads (22).

4. The sensitive key (16) according to one of the preceding claims, **characterised in that** the first and second external connection tracks (25a, 25b) are arranged outside the press zone (17) delimited by the pads (22) of the first and second electrodes (7, 9).

5. The sensitive key (16) according to one of the preceding claims, **characterised in that** each disc (22) has a square shape with an edge measuring between 1 and 2.5 mm, preferably equal to 1.6 mm.

6. The sensitive key (16) according to any one of the preceding claims, **characterised in that** the pads (22) and the internal tracks (24) are screen-printed with transparent ink, for example based on poly(3,4-ethylenedioxythiophene).

7. The sensitive key (16) as claimed in claim 3, **characterised in that** the first and second external connection tracks (25a, 25b) are screen-printed with ink based on silver microparticles.

8. A capacitive film (10) comprising at least two touch-sensitive keys (16), circuitry (26, 28) connected to the sensitive keys and a near-field communication antenna (8), **characterised in that** each sensitive key is according to any one of the preceding claims and **in that** the capacitive film comprises a ground mesh (20).

9. The capacitive film (10) according to claim 8, **characterised in that** the near-field communication antenna (8) is placed in the centre of the capacitive film and two touchpads (12, 14), each comprising at least two touch-sensitive keys (16), are arranged on either side of the near-field communication antenna.

10. The capacitive film (10) according to one of claims 8 or 9, **characterized in that** it is produced by screen printing on different layers, with two levels of metallization for the first and second external connection tracks (25a, 25b) and the circuits (26; 28), a transparent conductive level for the electrodes, a dielectric level and a metallization level for the printing of the second antenna (8).

11. The capacitive film (10) according to claim 8 to 10, **characterised in that**:
• a first layer (30) comprising the first and second electrodes (7, 9);
• a second layer (32) comprising first and second external connecting tracks (25a, 25b)
• a third layer (34) comprising the near-field communication antenna (8);
• a fourth insulating layer (36) for bridges (27) crossing the tracks of the first and second circuits;
• a fifth layer (38) comprising bridges (27) crossing the tracks of the first and second circuits;
• a sixth layer (40) comprising a carbon ink arranged at the ends of the circuits (26, 28).

12. The capacitive film (10) according to one of claims 10 or 11, **characterised in that** the second antenna (8) is formed with a silver microparticle ink, the conductivity of which is greater than that of the ink used to form the external connection tracks (25a, 25b) and the circuits (26, 28).

13. A touch-sensitive housing (2) comprising a radio antenna (6) and a printed circuit, **characterised in that** it also comprises a capacitive film (10) according to any one of claims 8 to 12 and diodes for illuminating the touch-sensitive key(s) (16).

14. The touch-sensitive housing (2) according to claim 13, **characterized in that** it comprises a first connector (50), connected with a first arrangement of conductive tracks (21, 26, 28) some of which (26, 28) connect sensitive keys (16) arranged along rows and columns of the capacitive film (10), the conductive tracks being arranged parallel to each other at an edge (10A) of the capacitive film (10), the first connector coupling two external lateral tracks and the one or two central tracks (21) to ground, the remaining tracks on one side of the central track(s) forming a first detection circuit (28) connected to the sensitive keys located in the same row of the capacitive film (10), and the remaining tracks on the other side of the central track(s) forming the second detection circuit (26) connected to the sensitive keys located in the same column of the capacitive film (10).
